(19) Europäisches Patentamt / European Patent Office / Office européen des brevets

(11) **EP 2 663 046 A1**

(12) **EUROPEAN PATENT APPLICATION**

(43) Date of publication:
**13.11.2013 Bulletin 2013/46**

(51) Int Cl.:
*H04L 27/36* (2006.01)     *H03G 3/30* (2006.01)

(21) Application number: **12305504.8**

(22) Date of filing: **07.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventors:
• **Class, Ulrich**
**73035 Göppingen (DE)**
• **Weese, Kurt**
**71254 Ditzingen (DE)**

(74) Representative: **2SPL Patentanwälte**
**Postfach 15 17 23**
**80050 München (DE)**

Remarks:
Amended claims in accordance with Rule 137(2) EPC.

(54)     **Apparatus and method for slew-rate limitation**

(57)     Embodiments relate to a slew-rate limitation apparatus (300; 400), comprising a down-converter (305; 405) operable to down-convert an input signal (302; 402) having a signal bandwidth (BW) around an offset frequency ($f_o$) by said offset frequency to obtain a down-converted baseband signal (310; 410), a slew-rate limiter (320; 420) operable to limit a slew-rate of the down-converted baseband signal (310; 410) to a predefined slew-rate limit to obtain a slew-rate limited baseband signal (322; 422), and an up-converter (325; 425) operable to up-convert the slew-rate limited baseband signal (322; 422) to a higher frequency domain.

Fig. 3

**Description**

Embodiments of the present invention generally relate to field of slew-rate control and, in particular, to slew-rate limitation for protection of Power Amplifiers (PAs).

<u>Background</u>

Wireless networks are steadily growing and more and more systems for mobile communication are deployed. For example, multiple generations of cellular networks have been developed and introduced to the mass markets. With the continuous extension and improvement of these wireless communication systems their inherent power consumption becomes more and more an issue. One of the major contributors to the power consumption of wireless communication systems are their base station transceivers, which are deployed to provide an almost 100% service coverage. The power consumption of a base station transceiver depends on several factors, where one major factor is the power consumption of the PAs used for transmission of the Radio Frequency (RF) signals, wherein a RF signal is a signal in a transmission frequency band, typically around a carrier frequency around several hundred MHz to several GHz. Power amplifiers are the most power consuming parts within a radio base station transceiver. Therefore the efficiency of the PA is critical to the overall power consumption of a base station transceiver and further to the power consumption of an entire wireless network.

Legacy 2nd Generation (2G) or 2.5G mobile communication systems, such as e.g. GSM/EDGE (Global System for Mobile Communications/Enhanced Data Rates for GSM Evolution), have made use of Frequency Division Multiple Access (FDMA) and/or Time Division Multiple Access (TDMA) schemes, where different user signals can be distinguished by their time and/or frequency characteristics in the transmission band. While GSM employs modulation techniques (e.g. Gaussian Minimum Shift Keying, GMSK) that can be combined with nonlinear PAs, modem wireless communication networks, such as EDGE, Wideband Code Division Multiple Access (WCDMA), Worldwide Interoperability for Microwave Access (WiMAX), and Long-Term Evolution (LTE), employ spectrum efficient $M$-ary Phase Shift Keying (M-PSK), Code Division Multiple Access (CDMA) or Orthogonal Frequency Division Multiple Access (OFDMA) modulation techniques that result in communication signals characterized by high amplitude variations, i.e. higher Peak-to-Average Power Ratios (PAPRs). To avoid the loss of transmitted information through distortion during amplification, highly linear transmitters are needed. However, typical linear transmitters are rather power inefficient. Several PA architectures have been proposed to improve the achievable power efficiency while meeting the communication system standards' linearity requirements. These architectures either consist of using continuously driven PAs, mainly class AB or Doherty, along with techniques for mitigating non-ideal transmitter behavior, such as e.g. linearization techniques, like digital predistortion and/or digital IQ imbalance compensation. Also, utilizing these digital pre-processing technologies, so-called multi-carrier or multi-band amplifier assemblies can be constructed that achieve high efficiencies and offer the ease of a predominately digital manufacturing environment.

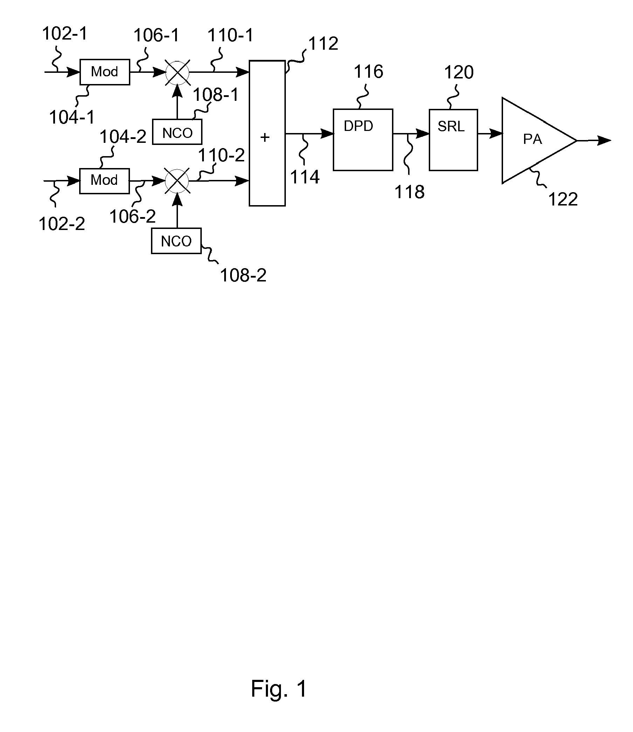

Fig. 1 shows a schematic block diagram of a transmit signal chain 100 of a multi-carrier base station, which can principally be used for multi-carrier WCDMA and/or multi-carrier GSM/EDGE systems, for example.

Digital baseband signal streams 102-1 and 102-2 corresponding to two distinct carriers or center frequencies may be digitally modulated by respective digital baseband modulator entities 104-1, 104-2 to obtain modulated digital baseband signals 106-1, 106-2. The modulated digital baseband signals 106-1, 106-2, each having a signal bandwidth BW1 and BW2, may then each be digitally up-converted in frequency by an associated signal-branch-specific Numerically Controlled Oscillator (NCO) 108-1 and 108-2 to obtain digitally up-converted signals 110-1, 110-2, respectively. Each of the digitally up-converted signals 110-1, 110-2 is shifted from the digital baseband domain (i.e. zero center frequency) by an associated frequency offset $f_{o,1}$ and $f_{o,2}$, wherein the frequency offsets $f_{o,1}$ and $f_{o,2}$ determine the (relative) positions of the center frequencies associated to the digital baseband signals 106-1 and 106-2 with the bandwidths BW1 and BW2. The digitally up-converted signals 110-1, 110-2 are then added together in block 112 to obtain a digital multi-carrier signal 114. The composite digital multi-carrier signal 114 may then be digitally predistorted by a digital predistortion entity 116 in order to precompensate nonlinearities and/or IQ-imbalances of a further downstream located PA 122. As the digital predistortion may effect undesired high signal variations in the composite digital multi-carrier signal 114 or components thereof, a slew-rate limiter 120 coupled in between the predistortion entity 116 and the PA 122 may be used to protect the power transistors of the PA 122.

One problem of many transistors used in common single- or multi-carrier PA circuits, in particular of base station transceivers, is their intolerance to overloads, voltage spikes or too high input signal slopes, wherein the latter is defined by a signal's slew-rate representing the maximum rate of change of a signal. The slew-rate may, for example, be expressed in units of V/$\mu$S. In order to protect power transistors from unwanted destruction due to a too high slew-rate of an input signal the slew-rate limiter 120 may be employed, which basically limits the first derivative of the signal passing through it. That is to say, the slew-rate limiter's output changes no faster than a specified or predefined (maximum) slew-rate limit.

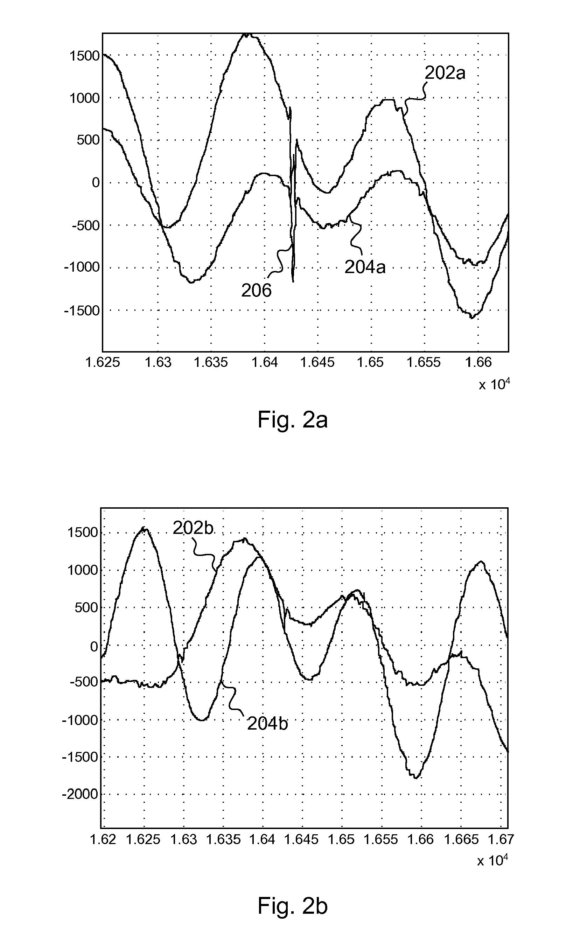

For example, Fig. 2a and Fig. 2b illustrate signal curves of baseband signals without and with slew-rate limitation. Fig. 2a shows a real part 202a and an imaginary part 204a of a baseband signal, wherein the real part 202a comprises a signal peak 206 which may have been introduced by a digital predistortion entity, for example. If left unlimited or uncompensated, the peak 206 may destroy a power transistor of a PA stage. Hence, a slew-rate limiter may be employed for mitigating such peaks and their destructive effects. For comparison, Fig. 2b illustrates slew-rate limited real 202b and imaginary parts 204b of the baseband signal.

Turning back to Fig. 1, the joint bandwidth of the multi-carrier signal 114 is broader than the bandwidth BW1 or BW2 of the individual digital baseband signals 106-1, 106-2. Hence, the multi-carrier signal 114 will also comprise higher frequency components leading to higher signal slopes, and hence a higher slew-rate, compared to the individual digital baseband signals 106-1, 106-2. Thus, the slew-rate limit of the slew-rate limiter 120 would have to be adapted to the joint bandwidth of the multi-carrier signal 114. This, however, would also lead to the problem that spikes or too high input signal slopes caused by the digital predistortion block 116 and lying within multi-carrier signal parts corresponding to the digital baseband signals 106-1, 106-2 would not be limited properly by the slew-rate limiter 120. Hence, it is desirable to improve this situation.

## Summary

It is one finding of the present invention that a frequency-shifted signal having a certain non-zero center frequency or offset frequency $f_o$ ($\neq 0$) and a given signal bandwidth BW around said offset frequency $f_o$ may be appropriately slew-rate-limited in the baseband domain, i.e., when the center frequency or offset frequency $f_o$ of the signal is zero, i.e., $f_o = 0$. While the frequency-shifted signal has frequency components in a frequency interval of $f_o \pm BW/2$, the down-shifted baseband signal only has frequency components in a frequency interval of $\pm BW/2$. According to embodiments of the present invention a slew-rate limiter may advantageously be adjusted to the actual signal bandwidth BW and the additional frequency offset $f_o$, which is problematic for an appropriate slew-rate limitation of the signal having the signal bandwidth BW, does not need to be taken into account. After the slew-rate-limitation has been performed in the baseband domain (i.e. $f_o = 0$) the slew-rated limited baseband signal may be converted back to the frequency offset domain (i.e. $f_o \neq 0$) or an even higher frequency domain, such as, for example, a transmission band in the Radio Frequency (RF) domain. The frequency offset domain may also be denoted as intermediate frequency domain throughout this specification.

According to a first aspect of the present invention it is provided a slew-rate limitation apparatus. The slew-rate limitation apparatus comprises a (frequency) down-converter which is operable to down-convert an input signal having a signal bandwidth BW around an offset frequency $f_o$ ($\neq 0$) by said offset frequency $f_o$ to obtain a down-converted baseband signal (having essentially no offset frequency, i.e., $f_o = 0$). Further, the slew-rate limitation apparatus comprises a slew-rate limiter which is operable to limit a slew-rate of the down-converted baseband signal to a predefined (maximum and/or minimum) slew-rate limit to obtain a slew-rate limited baseband signal. The slew-rate limitation apparatus also comprises an (frequency) up-converter which is operable to up-convert the slew-rate limited baseband signal to a higher frequency domain.

A slew-rate limitation apparatus according to embodiments may be used in various systems employing power amplifiers which have to be protected, such as, for example, in audio signal systems as well as in wireless communication systems, such as, for example, wireless communication systems standardized by the 3rd Generation Partnership Project (3GPP), such as the Global System for Mobile Communications (GSM), Enhanced Data rates for GSM Evolution (EDGE), GSM/EDGE Radio Access Network (GERAN), Universal Terrestrial Radio Access Network (UTRAN) or Evolved UTRAN (E-UTRAN), Long Term Evolution (LTE) or LTE-Advanced (LTE-A), or wireless communication systems with different standards, e.g. Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc. In the following the terms wireless communication system and mobile communication network may be used synonymously. Note that the concept of the present invention is not limited to the aforementioned wireless communication systems but is also applicable to other as well as future wireless communication system standards.

Furthermore, the slew-rate limitation apparatus may be deployed in or coupled to a single- or multi-carrier (single- or multi-band) base station transceiver. Such a single- or multi-carrier base station transceiver can be located in the fixed or stationary part of the network or system. A base station transceiver may correspond to a Remote Radio Head (RRH), a transmission point, an access point, a macro cell, a small cell, a micro cell, a femto cell, a metro cell etc. A base station transceiver can be a wireless interface of a wired network, which enables transmission of radio signals in different RF bands to an associated User Equipment (UE) or mobile terminal. Such a radio signal may comply with radio signals as, for example, standardized by 3GPP or, generally, in line with one or more of the above listed systems. Thus, a base station may correspond to a NodeB, an eNodeB, a BTS, an access point, etc.

Although embodiments of the present invention will be described with reference to a base station transceiver, other embodiments to not preclude (but may include) a transceiver apparatus coupled to or located in a mobile terminal, wherein a mobile terminal may correspond to a smartphone, a cell phone, user equipment, a laptop, a notebook, a personal computer, a Personal Digital Assistant (PDA), a Universal Serial Bus (USB) - stick, a car, etc. As mentioned before, a mobile terminal may also be referred to as User Equipment (UE) in line with the 3GPP terminology. Further, the multiband transceiver apparatus may also be coupled to a relay station for relaying wireless signals from a base station to a mobile terminal, and vice versa.

Although not limited thereto, the slew-rate limitation apparatus may be adapted to perform the slew-rate limitation completely in the digital signal domain, according to some embodiments. That is to say, both the frequency-shifted input signal centered at the offset frequency and the down-converted baseband signal may be digital signals comprising digital signal samples, respectively. In this case the down-converter and the up-converter may both be coupled to at least one Numerically Controlled Oscillator (NCO) operating at said non-zero offset frequency $f_o$. Thereby a NCO denotes a digital signal generator which may create a synchronous (i.e. clocked), discrete-time, discrete-valued representation of a waveform, usually a sinusoidal waveform.

A slew-rate limitation apparatus according to embodiments may be employed in multi-carrier transceivers for performing signal-branch-, signal-carrier-, or signal-band-specific slew-rate limitation. That is to say, not the composite and predistorted intermediate-frequency multi-carrier signal is slew-rate limited. Instead, the individual carrier-specific signal components thereof may be down-shifted to the baseband by their respective offset frequency, signal bandwidth-specific slew-rate limitation may be applied to the down-shifted baseband signal, and after that the signal may be up-shifted again either to its intermediate offset frequency or to an even higher RF frequency.

Also, many wireless communication systems use a feature called frequency hopping. Thereby, frequency hopping is performed by changing carrier frequencies while communicating. That is to say, frequency hopping is mechanism in which the system may change its system carrier frequency (uplink and downlink) during transmission at regular intervals, for example, in order to combat undesired effects due to frequency selective multipath fading. Quickly changing the system's carrier frequency may, for example, be performed (digitally) by applying hopping-specific offset frequencies to a (digital) baseband signal before digital predistortion and amplification. Embodiments of the present invention may, for example, also be used for slew-rate limitation in such frequency hopping scenarios.

According to yet a further aspect of the present invention it is also provided a slew-rate limitation method. The method comprises a step of down-converting an input signal having a signal bandwidth BW (centered) around an offset frequency $f_o$ by said offset frequency to obtain a down-converted baseband signal. The method further comprises a step of limiting a slew-rate of the down-converted baseband signal to a predefined slew-rate limit to obtain a slew-rate limited baseband signal. Also, the method comprises a step of up-converting the slew-rate limited baseband signal to a higher frequency domain.

Some embodiments comprise a digital control circuit installed within the apparatus for performing the method, i.e. the slew-rate limitation apparatus. Such a digital control circuit, e.g. a digital signal processor (DSP) or an Application-Specific Integrated Circuit (ASIC), needs to be programmed accordingly. Hence, yet further embodiments also provide a computer program having a program code for performing embodiments of the method, when the computer program is executed on a computer or a digital processor.

Embodiments may protect power transistors in PAs from being destroyed by overloads, voltage spikes or too high input signal slopes. Hence, the failure of hardware modules in the field may be reduced, thus saving maintenance costs and increasing customer satisfaction.

**Brief description of the Figures**

Some embodiments of apparatuses and/or methods will be described in the following by way of example only, and with reference to the accompanying figures, in which

Fig. 1    shows a schematic block diagram of a transmit signal chain of a multi-carrier base station transceiver;

Fig. 2a    shows exemplary real and imaginary parts of a signal without slew-rate limitation;

Fig. 2b    shows exemplary real and imaginary parts of a signal with slew-rate limitation;

Fig. 3    shows a schematic block diagram of a slew-rate limitation apparatus, according to an embodiment;

Fig. 4a    shows a schematic block diagram of a digital slew-rate limitation apparatus, according to a further embodiment; and

Fig. 4b    shows a schematic block diagram of a slew-rate limiter.

## Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent  to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

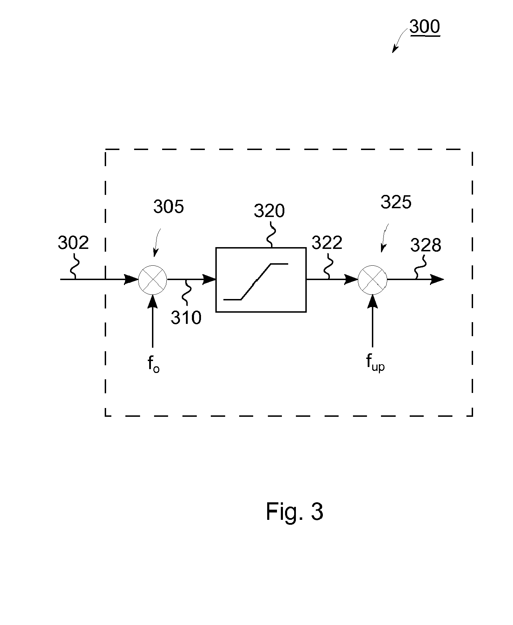

Fig. 3 shows a schematic block diagram of a slew-rate limitation apparatus 300, according to an embodiment of the present invention.

As has been explained before, the slew-rate limitation apparatus 300 may e.g. be deployed in an audio signal transceiver or in a wireless communication system transceiver, such as in a single- or multi-carrier base station transceiver, as well as in a mobile terminal transceiver. In particular, the slew-rate limitation apparatus 300 may be deployed upstream (i.e. before) to a power amplifier device for its protection.

An input signal 302 is coupled to an input of the slew-rate limitation apparatus 300. The input signal 302 has a center or offset frequency (intermediate frequency) which is different from zero, i.e. $f_o \neq 0$. Furthermore the input signal 302 has a (useful) signal bandwidth BW centered at said offset frequency $f_o$. In some embodiments the offset frequency $f_o$ may be regarded as an intermediate frequency and, hence, the input signal 302 may be regarded as an intermediate frequency domain signal. In embodiments related to wireless communication systems, the input signal 302 may be compliant to a wireless communication standard, such as , for example, a version of the GSM/EDGE, UMTS or LTE standard. For a GSM-compliant signal, the signal bandwidth BW may be 25 MHz, for example. According to embodiments the input signal's offset frequency $f_o$ may be a frequency from a frequency-interval reaching from several tens of MHz (Megahertz) to several hundreds of MHz. For example, in some embodiments the signal's 302 center or offset frequency $f_o$ can be a frequency from the frequency-interval from -37.5 MHz to +37.5 MHz.

The slew-rate limitation apparatus 300 comprises a down-converter 305 which is operable to down-convert the input signal 302 by said offset frequency $f_o$ to obtain a down-converted baseband signal 310 having essentially zero frequency offset, i.e. for = 0. The down-converter 305 may hence be understood as a frequency down-converter. Such a frequency down-converter may comprise analog and/or a digital mixer circuitry for down-mixing the intermediate-frequency input signal 302 by its offset frequency $f_o$ to the baseband domain, such that the signal bandwidth BW is centered at zero. Hence, a baseband domain signal is to be understood as a signal having a center frequency which is zero or essentially zero, which means that a baseband signal has essentially no offset frequency. In order to down-convert the input signal 302 from the offset frequency $f_o$ to  zero, the down-converter 305 may be adapted to down-mix the input signal 302 with a sinusoidal signal oscillating with the offset frequency $f_o$.

The slew-rate limitation apparatus 300 further comprises an analog or digital slew-rate limiter circuitry 320 which is adapted to limit a slew-rate, i.e., a maximum rate of change, of the down-converted baseband signal 310 to a predefined (maximum) slew-rate limit to obtain a slew-rate limited baseband signal 322 at the slew-rate limiter's output. Thereby, the slew-rate limit may be associated to the signal bandwidth BW and/or a maximum slew-rate which is tolerable by a power transistor of a power amplifier, which may be arranged downstream to (i.e. after) the slew-rate limitation apparatus 300. If the signal bandwidth BW is, for example, 25 MHz and the offset frequency $f_o$ is, for example, +37.5 MHz, leading to frequency components of up to 62.5 MHz in the input signal 302, the maximum slew-rate limit may nonetheless be associated to the signal bandwidth of 25 MHz. That is to say, the slew-rate limiter 320 may be adapted to limit signal slopes to a slew-rate limit which corresponds to the highest frequency components of the signal bandwidth BW of the input signal 302. The slew-rate limiter 320 may hence not allow signal slopes that correspond to higher frequencies than BW = 25 MHz, for example. If such a slew-rate limiter 320 was directly applied to the input signal 302 with the offset frequency $f_o$ (e.g. $f_o$ = +37.5 MHz ), the outcome would be an awfully distorted signal.

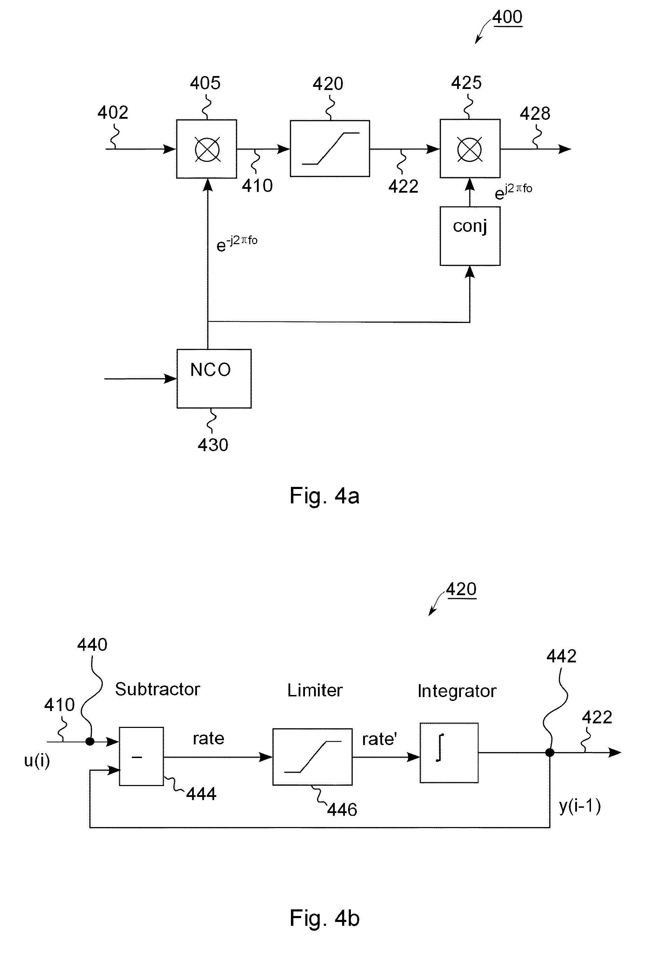

Further, the slew-rate limitation apparatus 300 comprises an up-converter 325 which is operable up-convert the slew-rate limited baseband signal 322 to a higher frequency domain, i.e. to a center frequency larger than zero, in order to obtain an up-converted slew-rate limited signal 328. That means that the up-converter 325 may mix the slew-rate limited baseband signal 322 with a sinusoidal reference signal oscillating with a frequency $f_{up}$ different from zero, i.e. $f_{up} \neq 0$. In some embodiments the frequency $f_{up}$ may correspond to the offset frequency $f_o$ (i.e. $f_{up} = f_o$) such that the up-converted slew-rate limited signal 328 is also centered on the offset frequency $f_o$. In other words, according to some embodiments, the up-converter 305 may be operable to up-convert the slew-rate limited baseband signal 322 by the offset frequency $f_o$ to obtain an up-converted slew-rate limited signal 328 having the signal bandwidth BW around the offset frequency $f_o$. For that purpose the down-converter 305 and/or the up-converter 325 may be coupled to an analog or digital reference oscillator which is operable to provide a reference signal oscillating with the offset frequency $f_o$. For example, the up-converter 325 may be operable to up-convert the slew-rate limited baseband signal 322 by means of a complex conjugated version of the reference signal which has been used for down-converting the input signal 302. This will be explained in further detail with reference to Fig 4a. According to other embodiments the up-converter 325 may also be adapted to convert the slew-rate limited baseband signal's center frequency from zero up to an RF transmission frequency which may be several hundreds of MHz or even several GHz, depending on the wireless communication system's spectrum allocation.

Generally, embodiments of the slew-rate limitation apparatus 300 may operate on analog as well as on digital signals. That is to say, the signals 302, 310, 322, and 328 may all be analog signals in some embodiments. In this case, the down-converter 305, the slew-rate limiter 320, and the up-converter may be analog electrical circuits, respectively, and the slew-rate limiter 320 may be adapted to limit the slew-rate to the predefined slew rate limit in an analog way. However, in preferred embodiments the signals 302, 310, 322, and 328 may all be digital signals. In other words the slew-rate limitation apparatus 300 may be adapted to work in the digital signal domain.

An exemplary digital embodiment of a slew-rate limitation apparatus 400 is schematically shown in Fig. 4a.

The slew-rate limitation apparatus 400 is fed with a digital input signal 402 having the signal bandwidth BW around the offset frequency $f_o$. According to an embodiment the digital input signal 402 may be a digitally modulated and frequency-shifted signal according to a wireless communication system standard. The digital frequency-shift by $f_o$ may, for example, be due to a multi-carrier and/or due to a frequency hopping application. For example, the digital input signal 402 may be a frequency-shifted digital baseband signal according to a version of the GSM/EDGE communications standard. Said digital input signal 402 is fed to a digital down-converter 405 which is adapted to digitally down-convert the center frequency $f_o$ of the input signal 402 from the intermediate frequency domain to the digital baseband domain of to obtain a down-converted digital baseband signal 410 having essentially zero offset frequency. For this purpose the down-converter 405 may comprise or may be coupled to a digital reference signal source 430 providing a digital reference signal (e.g. $e^{-j2\pi f_o}$) rotating or oscillating with the offset frequency $f_o$. For example, the digital reference source 430 may comprise a Numerically Controlled Oscillator (NCO) operating at the offset frequency $f_o$. A NCO typically comprises a phase accumulator, which adds to a value held at its output a programmable frequency control value 432 at each clock sample. Hence, the offset frequency $f_o$ may be programmable at least within a predefined offset frequency bandwidth. Further, a phase-to-amplitude converter may use a phase accumulator's output word (phase word) as an index into a waveform Look-Up Table (LUT) to provide a corresponding amplitude sample. Other methods of converting phase to amplitude, including mathematical algorithms such as power series can be used, particularly in a software-based NCO. Hence, the digital down-converter 405 may multiply the digital frequency-shifted input signal 402 with the digital reference signal from the NCO 430.

The obtained down-converted digital baseband signal 410 may then be provided to a digital slew-rate limiter 420 which is adapted to limit the slew-rate of the down-converted digital baseband signal 410 to a predefined slew-rate limit. The digital slew-rate limiter 420 may then provide a slew rate limited digital baseband signal 422 at its output. The slew-rate limiter 420 may limit the first derivative of the signal 410 passing through it. The output changes no faster than the specified slew-rate limit. The signal's derivative may be determined according to

$$rate = [u(i) - y(i\text{-}1)]/[t(i) - t(i\text{-}1)], \qquad (1)$$

wherein $u(i)$ and $t(i)$ are the current input sample and time, and $y(i\text{-}1)$ and $t(i\text{-}1)$ are the output and time at the previous step. The current output may be determined by comparing *rate* to rising slew rate and falling slew rate parameters, which may be associated to the signal bandwidth BW and/or a maximum slew rate which is tolerable by power transistors of a power amplifier arranged downstream to the slew-rate limitation apparatus 400. That is to say, according to embodiments the rising slew rate and falling slew rate parameters may be chosen independent of thee offset frequency $f_o$. If *rate* is greater than the rising slew rate parameter (R), the output may be determined according to $y(i) = \Delta tR + y(i-1)$. If *rate* is less than the falling slew rate parameter (F), the output may be determined according to $y(i) = \Delta tF + y(i-1)$. If *rate* is between the bounds of R and F, the change in output is equal to the change in input, i.e. $y(i) = u(i)$.

The resulting slew rate limited digital baseband signal 422 may then be coupled to a digital up-converter 425 which is, in this embodiment, operable to up-convert the slew-rate limited digital baseband signal 422 by the offset frequency $f_o$ to obtain an up-converted slew-rate limited digital signal 428 having the signal bandwidth BW around the offset frequency $f_o$. As can be seen from Fig. 4a the slew rate limited digital baseband signal 422 may, for this purpose, be multiplied with a complex-conjugated version of the reference oscillating signal coming from the NCO 430 (e.g. $e^{+j2\pi fo}$).

As can be seen from Fig. 4b, the digital slew-rate limiter 420 may comprise an input 440 for the down-converted digital baseband signal 410, as well as an output 442 for the slew-rate limited baseband signal 422. Further, the digital slew-rate limiter 420 may comprise a subtractor 444 which is coupled to the input 440 as well as to the output 442. The subtractor 444 serves for determining the slew-rate *rate* of the down-converted baseband signal 410 based on the down-converted baseband signal 410 and the slew-rate limited baseband signal 422 at the output 442 (see Eq. (1)). The determined slew-rate *rate* may be limited by a limiter 446 to obtain a limited slew-rate *rate'(= rate, R,* or F), which may then be fed to an integrator 448 for integrating the limited slew-rate *rate'* in order to obtain the slew-rate limited baseband signal 422 at the output 442 of the digital slew-rate limiter 420. An analog slew-rate limiter may work similarly.

In some embodiments a slew-rate limitation apparatus 300, 400 may be deployed between a digital predistortion device for mitigating Tx noise of a RF transmitter and said RF transmitter (comprising a PA) for transmitting the slew-rate limited baseband signal. For example, a slew-rate limitation apparatus according to embodiments of the present invention may advantageously be deployed in a multiband or multicarrier transceiver, which has been explained before. Here, embodiments of the slew-rate limitation apparatus 300, 400 may be employed to limit the slew-rates of the individual signals corresponding to the individual carriers of the multicarrier signal. In some embodiments a 25 MHz wide digital baseband signal may be shifted by an offset frequency within a range of ±37.5 MHz. As a result frequency components of the resulting intermediate or multi-carrier signal may be up to 75 MHz, thus leading to much higher or steeper signal slopes compared to the 25 MHz wide baseband signal. The reason for the higher signal slopes in the intermediate signal is its higher frequency offset $f_o$. Due to the fact, that all individual carriers are lying inside a 25 MHz bandwidth, the individual signal can be down-shifted to about zero frequency. Then the slew-rate limiter 320, 420 according to embodiments may be applied. The slew-rate limited signal may then be shifted back to its original frequency offset $f_o$. Shifting back can e.g. be done by means of a conjugated complex NCO signal, as has been explained with reference to Fig. 4a.

To summarize, embodiments of the present invention may help to protect PAs or power transistors thereof from being destroyed by too high slew-rates of the PA's input signals. Thus failure of transmitter hardware modules in the field may be reduced, hence saving costs and increasing customer satisfaction.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1. A slew-rate limitation apparatus (300; 400), comprising:

   a down-converter (305; 405) operable to down-convert an input signal (302; 402) having a signal bandwidth (BW) around an offset frequency ($f_o$) by said offset frequency to obtain a down-converted baseband signal (310; 410);
   a slew-rate limiter (320; 420) operable to limit a slew-rate of the down-converted baseband signal (310; 410) to a predefined slew-rate limit to obtain a slew-rate limited baseband signal (322; 422); and
   an up-converter (325; 425) operable to up-convert the slew-rate limited baseband signal (322; 422) to a higher frequency domain.

2. A slew-rate limitation apparatus (300; 400) according to claim 1, wherein up-converter (325; 425) is operable to up-convert the slew-rate limited baseband signal (322; 422) by the offset frequency ($f_o$) to obtain an up-converted slew-rate limited signal (328; 428) having the signal bandwidth (BW) around the offset frequency ($f_o$).

3. The slew-rate limitation apparatus (300; 400) according to claim 1, wherein the down-converter (305; 405) and/or the up-converter (325; 425) is coupled to a reference oscillator (430) which is operable to provide a reference signal oscillating with the offset frequency ($f_o$).

4. The slew-rate limitation apparatus (300; 400) according to claim 3, wherein the up-converter (325; 425) is operable to up-convert the slew-rate limited baseband signal (322; 422) by means of a complex conjugated version of the reference signal used for down-converting the input signal (302; 402).

5. The slew-rate limitation apparatus (300; 400) according to claim 1, wherein the input signal (302; 402) and the down-converted baseband signal (310; 410) are both digital signals and wherein the down-converter (305; 405) and the up-converter (325; 425) are both coupled to at least one Numerically Controlled Oscillator (NCO; 430) providing a digital reference signal oscillating with the offset frequency ($f_o$).

6. The slew-rate limitation apparatus (300; 400) according to claim 1, wherein the slew-rate limit is associated to the signal bandwidth (BW) and/or a maximum slew rate which is tolerable by power transistors of a power amplifier (122) arranged downstream to the slew-rate limitation apparatus (300; 400).

7. The slew-rate limitation apparatus (300; 400) according to claim 1, wherein the slew-rate limiter (320; 420) comprises an input (440) for the down-converted baseband signal (310; 410),
   an output (442) for the slew-rate limited baseband signal (322; 422),
   a subtractor (444) coupled to the input (440) and the output (442) for determining the slew-rate of the down-converted baseband signal (310; 410) based on the down-converted baseband signal (310; 410) and the slew-rate limited baseband signal (322; 422),

a limiter (446) for limiting the determined slew-rate, and

an integrator (448) for integrating the limited slew-rate to obtain the slew-rate limited baseband signal (322; 422) at the output (442) of the slew-rate limiter (320; 420).

**8.** The slew-rate limitation apparatus (300; 400) according to claim 1, wherein the offset frequency ($f_o$) is programmable within a predefined offset frequency bandwidth.

**9.** The slew-rate limitation apparatus (300; 400) according to claim 1, wherein the signal bandwidth (BW) of the input signal (302; 402) is 25 MHz and the input signal's offset frequency ($f_o$) is a frequency from a frequency interval of -37.5 MHz to +37.5 MHz.

**10.** The slew-rate limitation apparatus (300; 400) according to claim 1, wherein the input signal (302; 402) is a signal according to a wireless communication system standard, in particular, according to a version of the GSM-, UMTS-, or LTE-standard.

**11.** A transceiver apparatus comprising the slew-rate limitation apparatus (300; 400) according to claim 1.

**12.** The transceiver apparatus according to claim 11, wherein the slew-rate limitation apparatus (300; 400) is coupled in between a digital predistortion device (116) for mitigating transmit noise of a Radio Frequency (RF) transmitter and said RF transmitter (122) for transmitting the slew-rate limited baseband signal (322; 422).

**13.** A slew-rate limitation method, comprising:

down-converting an input signal (302; 402) having a signal bandwidth (BW) around an offset frequency ($f_o$) by said offset frequency to obtain a down-converted baseband signal (310; 410);

limiting a slew-rate of the down-converted baseband signal (310; 410) to a predefined slew-rate limit to obtain a slew-rate limited baseband signal (322; 422); and

up-converting the slew-rate limited baseband (322; 422) signal to a higher frequency domain.

**14.** A computer program having a program code for performing the method of claim 13, when the computer program is executed on a computer or processor.

**Amended claims in accordance with Rule 137(2) EPC.**

**1.** A slew-rate limitation apparatus (300; 400), comprising:

a down-converter (305; 405) operable to down-convert an input signal (302; 402) having a signal bandwidth (BW) around an offset frequency ($f_o$) by said offset frequency to obtain a down-converted baseband signal (310; 410);

a slew-rate limiter (320; 420) operable to limit a slew-rate of the down-converted baseband signal (310; 410) to a predefined slew-rate limit to obtain a slew-rate limited baseband signal (322; 422); and

an up-converter (325; 425) operable to up-convert the slew-rate limited baseband signal (322; 422) to a higher frequency domain.

**2.** A slew-rate limitation apparatus (300; 400) according to claim 1, wherein up-converter (325; 425) is operable to up-convert the slew-rate limited baseband signal (322; 422) by the offset frequency ($f_o$) to obtain an up-converted slew-rate limited signal (328; 428) having the signal bandwidth (BW) around the offset frequency ($f_o$).

**3.** The slew-rate limitation apparatus (300; 400) according to claim 1, wherein the down-converter (305; 405) and/or the up-converter (325; 425) is coupled to a reference oscillator (430) which is operable to provide a reference signal oscillating with the offset frequency ($f_o$).

**4.** The slew-rate limitation apparatus (300; 400) according to claim 3, wherein the up-converter (325; 425) is operable to up-convert the slew-rate limited baseband signal (322; 422) by means of a complex conjugated version of the reference signal used for down-converting the input signal (302; 402).

**5.** The slew-rate limitation apparatus (300; 400) according to claim 1, wherein the input signal (302; 402) and the down-converted baseband signal (310; 410) are both digital signals and wherein the down-converter (305; 405) and the up-converter (325; 425) are both coupled to at least one Numerically Controlled Oscillator (NCO; 430) providing a digital reference signal oscillating with the offset frequency ($f_o$).

**6.** The slew-rate limitation apparatus (300; 400) according to claim 1, wherein the slew-rate limit is associated to the signal bandwidth (BW) and/or a maximum slew rate which is tolerable by power transistors of a power amplifier (122) arranged downstream to the slew-rate limitation apparatus (300; 400).

**7.** The slew-rate limitation apparatus (300; 400) according to claim 1, wherein the slew-rate limiter (320; 420) comprises
an input (440) for the down-converted baseband signal (310; 410),
an output (442) for the slew-rate limited baseband signal (322; 422),
a subtractor (444) coupled to the input (440) and the output (442) for determining the slew-rate of the down-converted baseband signal (310; 410) based on the down-converted baseband signal (310; 410) and the slew-rate limited baseband signal (322; 422),
a limiter (446) for limiting the determined slew-rate, and
an integrator (448) for integrating the limited slew-rate to obtain the slew-rate limited baseband signal (322; 422) at the output (442) of the slew-rate limiter (320; 420).

**8.** The slew-rate limitation apparatus (300; 400) according to claim 7, wherein the slew-rate (*rate*) is determined based on

$$rate = [u(i) - y(i\text{-}1)]/[t(i) - t(i\text{-}1)],$$

wherein $u(i)$ and $t(i)$ are a current down-converted baseband signal sample and time, and $y(i\text{-}1)$ and $t(i\text{-}1)$ are a slew-rate limited baseband signal and time at a previous time instant.

**9.** The slew-rate limitation apparatus (300; 400) according to claim 1, wherein the offset frequency ($f_o$) is programmable within a predefined offset frequency bandwidth.

**10.** The slew-rate limitation apparatus (300; 400) according to claim 1, wherein the signal bandwidth (BW) of the input signal (302; 402) is 25 MHz and the input signal's offset frequency ($f_o$) is a frequency from a frequency interval of - 37.5 MHz to +37.5 MHz.

**11.** The slew-rate limitation apparatus (300; 400) according to claim 1, wherein the input signal (302; 402) corresponds to one of a plurality of carrier frequencies of a multicarrier signal.

**12.** A transceiver apparatus comprising the slew-rate limitation apparatus (300; 400) according to claim 1.

**13.** The transceiver apparatus according to claim 12, wherein the slew-rate limitation apparatus (300; 400) is coupled in between a digital predistortion device (116) for mitigating transmit noise of a Radio Frequency (RF) transmitter and said RF transmitter (122) for transmitting the slew-rate limited baseband signal (322; 422).

**14.** A slew-rate limitation method, comprising:

down-converting an input signal (302; 402) having a signal bandwidth (BW) around an offset frequency ($f_o$) by said offset frequency to obtain a down-converted baseband signal (310; 410);
limiting a slew-rate of the down-converted baseband signal (310; 410) to a predefined slew-rate limit to obtain a slew-rate limited baseband signal (322; 422); and
up-converting the slew-rate limited baseband (322; 422) signal to a higher frequency domain.

**15.** A computer program having a program code for performing the method of claim 14, when the computer program is executed on a computer or processor.

Fig. 1

Fig. 2a

Fig. 2b

300

302   305   320   325   328

322

310

$f_o$   $f_{up}$

Fig. 3

$400$

$402$   $405$   $420$   $425$   $428$

$410$   $422$

$e^{j2\pi fo}$

$e^{-j2\pi fo}$

conj

NCO

$430$

Fig. 4a

$420$

$440$

Subtractor   Limiter   Integrator

$442$

$410$   rate   rate'   $422$

$u(i)$

$444$

$446$

$y(i-1)$

Fig. 4b

Europäisches
Patentamt

European
Patent Office

Office européen
des brevets

## EUROPEAN SEARCH REPORT

**Application Number**

EP 12 30 5504

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 432 271 A (MOTOROLA INC [US]) 16 May 2007 (2007-05-16) | 1-6,8-13 | INV. H04L27/36 H03G3/30 |
| Y | * page 3, line 9 - page 4, line 2 * <br> * page 11, line 1 - page 12, line 23 * <br> * page 13, line 14 - line 26 * <br> * page 26, line 30 - page 27, last line * <br> * figure 1 * <br> ----- | 7 | |
| Y | EP 1 229 653 A1 (SEMICONDUCTOR IDEAS MARKET BV [NL]) 7 August 2002 (2002-08-07) <br> * paragraph [0026] * <br> * paragraph [0028] * <br> * figure 4 * <br> ----- | 7 | |
| X | US 5 041 793 A (GAILUS PAUL H [US]) 20 August 1991 (1991-08-20) <br> * column 1, line 5 - line 23 * <br> * column 1, line 58 - column 2, line 35 * <br> * column 4, line 63 - column 5, line 3 * <br> * figure 2 * <br> ----- | 1-4,6, 10,13,14 | |

**TECHNICAL FIELDS SEARCHED (IPC)**

H04L
H03G
H03F

The present search report has been drawn up for all claims

| Place of search | Date of completion of the search | Examiner |
|---|---|---|
| The Hague | 8 October 2012 | Moreno, Marta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 12 30 5504

This annex lists the patent family members relating to the patent documents cited in the above-mentioned European search report.
The members are as contained in the European Patent Office EDP file on
The European Patent Office is in no way liable for these particulars which are merely given for the purpose of information.

08-10-2012

| Patent document cited in search report | | Publication date | Patent family member(s) | | Publication date |
|---|---|---|---|---|---|
| GB 2432271 | A | 16-05-2007 | GB | 2432271 A | 16-05-2007 |
| | | | WO | 2007059484 A2 | 24-05-2007 |
| EP 1229653 | A1 | 07-08-2002 | EP | 1229653 A1 | 07-08-2002 |
| | | | EP | 1356591 A1 | 29-10-2003 |
| | | | US | 2004063414 A1 | 01-04-2004 |
| | | | WO | 02071613 A1 | 12-09-2002 |
| US 5041793 | A | 20-08-1991 | AU | 635672 B2 | 25-03-1993 |
| | | | AU | 8878291 A | 26-05-1992 |
| | | | CA | 2068420 A1 | 01-05-1992 |
| | | | CN | 1062817 A | 15-07-1992 |
| | | | DE | 69128417 D1 | 22-01-1998 |
| | | | DE | 69128417 T2 | 25-06-1998 |
| | | | EP | 0507919 A1 | 14-10-1992 |
| | | | ES | 2109278 T3 | 16-01-1998 |
| | | | HK | 1005921 A1 | 29-01-1999 |
| | | | JP | 3038916 B2 | 08-05-2000 |
| | | | JP | H05503407 A | 03-06-1993 |
| | | | US | 5041793 A | 20-08-1991 |
| | | | WO | 9208283 A1 | 14-05-1992 |

EPO FORM P0459

For more details about this annex : see Official Journal of the European Patent Office, No. 12/82